# EUROPÄISCHE PATENTANMELDUNG

(11) **EP 4 831 669 A1**
(43) Veröffentlichungstag der Anmeldung: **28.10.2026**
(21) Anmeldenummer: 25171844.1
(22) Anmeldetag: 23.04.2025
(51) Int. Cl.: G01R 33/34, G01R 33/341, G01R 33/3415

(54) **ANTENNE, ANTENNENANORDNUNG, VERFAHREN UND TOMOGRAPHIESYSTEM**

(71) Anmelder: Forschungszentrum Jülich GmbH, 52428 Jülich (DE)
(72) Erfinder: CHOI, Chang-Hoon, 52428 Jülich (DE); HONG, Suk-Min, 52146 Würselen (DE); FELDER, Jörg, 52428 Jülich (DE); SHAH, Nadim Joni, 52428 Jülich (DE)
(74) Vertreter: Gille Hrabal Partnerschaftsgesellschaft mbB Patentanwälte

(57) **Zusammenfassung**

Die Erfindung betrifft eine Antenne und eine Antennenanordnung für ein bildgebendes Verfahren, ein Verfahren, insbesondere für Magnetresonanztomographie (MRT) oder simultane Positronen-Emissions-Tomographie-MRT (PET-MRT). Eine reine Empfangsantenne (1) oder Antennenanordnung für ein hybrides bildgebendes Verfahren umfasst einen Gammastrahlen-transparenten Empfangsabschnitt (2) und einen Speisungsabschnitt (3) mit Abstimmungskomponenten.

## Beschreibung

Die Erfindung betrifft eine Antenne und eine Antennenanordnung für ein bildgebendes Verfahren, ein Verfahren zum Betreiben einer Antenne sowie ein Tomographiesystem, insbesondere für Magnetresonanztomographie (MRT) oder simultane Positronen-Emissions-Tomographie-MRT (PET-MRT).

Die Magnetresonanztomographie (MRT) ist ein nicht-invasives bildgebendes Verfahren zur Untersuchung von Körperteilen, mit dem hoch aufgelöste Schnittbilder des Körpers für die medizinische Diagnostik erzeugt werden können. Sie beruht auf der resonanten Anregung bestimmter im Körper enthaltener oder dem Körper zugeführter Atomkerne, insbesondere Wasserstoffkerne, mittels starker Magnetfelder und magnetischer Wechselfelder im Radiofrequenzbereich (Kernspinresonanz), die die Induktion eines elektrischen Signals in einer Empfangsantenne bewirkt. Ein starkes statisches Magnetfeld, das B0-Feld, wird von einem hochfrequenten magnetischen Wechselfeld, dem B1-Feld, überlagert. Die Frequenz von B1 ist proportional zum B0-Feld. Mit MRT können hoch aufgelöste Bilder erzeugt werden.

Zur Durchführung der MRT werden Hochfrequenz-Antennen - auch als Spulen bezeichnet - genutzt, die am zu untersuchenden Körper oder Körperteil bzw. um diesen oder dieses herum angeordnet werden. Die körpernahe Anordnung ist insbesondere bei Ultrahochfeld-MRT (magnetische Flussdichte ≥ 7T) der Fall, um eine größere Eindringtiefe zu ermöglichen und ein symmetrisches B1-Feldmuster zu erzeugen. Antennenanordnungen mit mehreren Antennen, die auch als Mehrkanalantennen, mehrkanalige Antennen oder (mehrkanalige) (Antennen-)Arrays bezeichnet werden, werden verwendet, um ein homogeneres oder räumlich ausgeweitetes Magnetfeld zu erzeugen, die Abdeckung zu vergrößern und/oder die Erfassung von Bildern zu beschleunigen. Mit einer Antennenanordnung können zudem bestimmte Körperteile optimal abgedeckt und untersucht werden. Eine Antennenanordnung erlaubt die Anordnung einer dem jeweiligen Fall angepassten Anzahl und ggf. Form und/oder Größe von Antennen, kann mit anderen Worten also als personalisierte/dedizierte Antennenanordnung bereitgestellt werden. Als Beispiel für derartige Antenne ist eine J-Pol-Antenne in der WO 2020 244 689 A1 beschrieben.

Bisherige Antennen haben insbesondere im Bereich der Speisung einen großen Platzbedarf. Dies schränkt einerseits die Anordnung der Antennen in Arrays ein. Außerdem führt der hohe Platzbedarf zu vergleichsweise großen wechselseitigen Kopplungen der Antennen in einer Antennenanordnung, insbesondere bei eng gepackten Antennen. Dies beruht auf elektromagnetischer Wechselwirkung zwischen den einzelnen Antennen. Dabei kommt es zu einer Änderung des B1-Musters und der Eingangsimpedanz. Zusätzliche Moden im Frequenzspektrum sind die Folge. Die Kopplung zweier Antennen nimmt bei zunehmendem Abstand ab. Somit ist die Anzahl der Antennen pro Fläche bzw. Volumen und damit die erreichbare Auflösung (über das erzielbare SNR) des bildgebenden Verfahrens begrenzt.

Die unveröffentlichte deutsche Patentanmeldung DE 10 2024 201 994.1 sowie die unveröffentlichte internationale Patentanmeldung PCT/EP2025/054936 betreffen eine kombinierte Sende- und Empfangsantenne.

Es ist die Aufgabe der Erfindung, eine verbesserte Antenne, Antennenanordnung, sowie ein verbessertes Verfahren und Tomographiesystem bereitzustellen. Insbesondere sollen die Nachteile des Standes der Technik zumindest teilweise behoben werden.

Die Aufgabe wird gelöst durch eine Antenne gemäß Anspruch 1 sowie durch die Antennenanordnung, das Verfahren und das Tomographiesystem gemäß den nebengeordneten Ansprüchen. Vorteilhafte Ausführungsformen sind in den Unteransprüchen angegeben.

Zur Lösung der Aufgabe dient eine Antenne für ein bildgebendes Verfahren. Die Antenne weist einen Empfangsabschnitt und einen Speisungsabschnitt auf. Der Speisungsabschnitt umfasst eine Kapazität und eine Induktivität. Diese können mit einem Vorverstärker verbunden sein.

Es hat sich gezeigt, dass mit einer Kapazität und einer Induktivität das Verhalten einer J-Pol-Antenne erreichen lässt, ohne dafür den Platzbedarf einer J-Pol-Antenne zu benötigen. Durch den geringen Platzbedarf kann eine dichte Antennenanordnung hergestellt werden, bei der eine vergleichsweise hohe Zahl an Antennen auf engem Raum untergebracht werden können, ohne dass die Kopplung der Antennen untereinander zu groß wird. So kann eine hocheffiziente Anordnung hergestellt werden. Durch die hohe Anzahl an Kanälen, also Antennen, pro Fläche und/oder Volumen kann die Leistung der parallelen Bildgebung erhöht und auch die Erfassungszeit verkürzt werden und damit das Signal-Rausch-Verhältnis erhöht werden. So wird die Qualität und Aussagekraft des Bildes weiter verbessert. Zudem kann die erfindungsgemäße Antenne mit Standardbauteilen und deshalb besonders kostengünstig und technisch einfach hergestellt werden. Insgesamt ist durch die Erfindung ein besonders einfacher Aufbau des Speisungsteils und damit der Antenne möglich.

Die Antenne kann grundsätzlich analog zu einer J-Pol-Antenne, einer Monopol-Antenne oder einer Dipol-Antenne ausgestaltet sein. Der Speisungsabschnitt einer solchen herkömmlichen Antenne ist dann erfindungsgemäß ausgestaltet. Es kann also eine herkömmliche Antenne durch Ersetzen des Speisungsabschnittes erfindungsgemäß ausgestaltet werden.

Der Empfangsabschnitt ist insbesondere zum Empfangen von elektromagnetischer Strahlung, insbesondere Magnetresonanzsignalen von einem Körper, eingerichtet. Der Empfangsabschnitt kann im Wesentlichen oder vollständig gerade sein. Es handelt sich typischerweise um eine lineare Antenne oder Stabantenne. Es kann jedoch auch ein gebogener Empfangsabschnitt vorgesehen werden. Insbesondere ist dieser Teil transparent für Gammastrahlung, so dass ein hybrider Betrieb unter Verwendung multimodaler Systems, also etwa MR-PET oder MR-SPECT ermöglicht wird. So kann die Antenne optimal an die räumlichen Gegebenheiten angepasst werden.

Der Speisungsabschnitt ist insbesondere dazu eingerichtet, den Empfangsabschnitt zu speisen. In einer Ausgestaltung ist die Antenne ist eine endgespeiste Antenne. Dies ist insbesondere bei J-Pol-Antennen und Monopolen der Fall. Hierdurch kann erreicht werden, dass das Kabel, das die Antenne mit dem MRT-System verbindet, nicht die Hauptantenne oder die Hauptantennenanordnung stört. Alternativ, insbesondere im Falle eines Dipols, befindet sich der Speisungsabschnitt ungefähr mittig in Bezug auf die Länge der Antenne.

Typischerweise sind Empfangsabschnitt und Speisungsabschnitt elektrisch miteinander verbunden. Der Speisungsabschnitt weist typischerweise einen ersten Anschluss auf und der Empfangsabschnitt weist typischerweise einen zweiten Anschluss auf. Die Verbindung des ersten Anschlusses und des zweiten Anschlusses kann zerstörungsfrei lösbar oder nicht zerstörungsfrei lösbar ausgestaltet sein. Der Empfangsabschnitt kann nahtlos in den Speisungsabschnitt übergehen. Der Empfangsabschnitt und der Speisungsabschnitt sind insbesondere benachbart, bevorzugt unmittelbar benachbart.

Insbesondere weist die Antenne einen Antennenanschluss zum Anschließen bzw. zur Speisung der Antenne auf. Der Antennenanschluss kann zum Anschließen eines Koaxialkabels geeignet sein. Bevorzugt weist der Speisungsabschnitt den Antennenanschluss auf. Der Speisungsabschnitt kann zudem einen oder mehrere Steuerungsanschlüsse aufweisen. Insbesondere weist der Empfangsabschnitt bis auf den zweiten Anschluss keine weiteren Anschlüsse auf.

Eine Kapazität und eine Induktivität sind elektrotechnische Bauteile. Kapazitäten und Induktivitäten werden auch als konzentrierte Bauteile (engl.: "lumped elements") bezeichnet. Insbesondere werden kompakte konzentrierte Bauteile verwendet. So kann ein besonders geringer Bauraum erreicht werden.

In einer Ausführungsform umfasst der Speisungsabschnitt einen Stromkreis bzw. eine Schaltung. Insbesondere umfasst der Stromkreis den Antennenanschluss, die Kapazität und die Induktivität. In einer Ausführungsform sind die Kapazität und die Induktivität in Reihe geschaltet. Insbesondere ist zudem der Antennenanschluss und/oder ein Abzweig zum ersten Anschluss zum Anschließen des Empfangsabschnitts mit der Induktivität und der Kapazität in Reihe geschaltet. Insbesondere ist der Antennenanschluss zwischen der Antenne und der Kapazität angeordnet. Insbesondere ist der Abzweig zum ersten Anschluss zwischen Kapazität der und der Antenne angeordnet, bevorzugt auf der dem Antennenanschluss gegenüberliegenden Seite. In einer Ausführungsform umfasst ein Stromkreis des Speisungsabschnitts in dieser Reihenfolge den Abzweig zum ersten Anschluss, die Induktivität, den Antennenanschluss und die Kapazität.

Die Kapazität ist insbesondere ein Kondensator oder ein Bauteil, das als Kondensator wirken kann, beispielsweise eine Kapazitätsdiode. Es kann ein Kondensator mit einer fixen Kapazität verwendet werden. Die Kapazität dient dazu, die Antenne an die gegebenen Bedingungen der konkreten Messung anzupassen. Beispielsweise kann die Impedanz zwischen der Antenne und dem Ausgang des zur Speisung vorgesehenen RF-Systems angepasst werden. Die Induktivität ist insbesondere eine Spule. Es kann eine Spule mit einer fixen Induktivität verwendet werden.

Die Antenne ist eine reine Empfangsantenne, also eine reine Empfangseinrichtung für ein bildgebendes Verfahren, beispielsweise für MRT oder MR-Spektroskopie. Die Antenne ist also nicht zum Senden vorgesehen und/oder geeignet. Die Antenne ist keine kombinierte Sende-Empfangs-Antenne. Zum Senden und Empfangen werden hierbei grundsätzlich unterschiedliche Antennen verwendet. Zum Senden wird dann eine andere, zusätzliche Antenne bzw. Antennenanordnung benötigt.

Wird anstelle einer kombinierten Sende-Empfangs-Antenne eine reine Empfangsantenne verwendet, beispielsweise in Kombination mit einer reinen Sendeantenne, hat dies grundsätzlich unterschiedliche Vorteile. Zum einen werden ein besonders hohes Signal-Rausch-Verhältnis und eine hohe Sensitivität erreicht. Zum anderen werden parallele Bildgebungsverfahren unterstützt, wie beispielsweise GRAPPA oder SENSE. Aufgrund der deutlich geringeren Leistung kann die Antenne viel näher am Zielobjekt positioniert werden, was die Empfindlichkeit verbessert.

Die Antenne weist insbesondere keinen Schalter zum Umschalten zwischen Sende- und Empfangsfunktion, keinen Leistungsteiler zur Teilung der Sendeleistung bzw. zur Anpassung der Sendephasen wie beispielsweise einen Wilkinson-Teiler, keine Sendestromquelle bzw. keinen Leistungsverstärker und/oder keinen Phasenschieber zum Schutz des Vorverstärkers auf. Derartige Bauteile einer kombinierten Sende-Empfangsantenne sind bei einer reinen Empfangsantenne nicht notwendig. Somit ist die erfindungsgemäße Empfangsantenne kostengünstiger und einfacher herstellbar als eine kombinierte Sende-Empfangsantenne mit derselben Anzahl an Kanälen. Selbstverständlich ist es nicht ausgeschlossen, dass ein Leistungsteiler zur Kombination des Empfangssignals mehrerer Vorverstärker, z. B. aus mehreren Antennen bzw. Kanälen, genutzt wird, insbesondere in einer Empfangsantennenanordnung mit mehreren Empfangsantennen.

Im Vergleich zu konventionellen reinen Empfangsspulen kann die erfindungsgemäße Empfangsantenne PET-kompatibel sein. Beispielsweise kann der Empfangsabschnitt PET-transparent bzw. zumindest im Wesentlichen transparent für Gammastrahlen sein. Die Antenne kann daher für hybride Systeme z. B. MR-PET verwendet werden.

Eine Elektronik der Antenne oder der Antennenanordnung und/oder eine Empfangs- und/oder Auswerteinheit der Antenne oder der Antennenanordnung ist insbesondere dazu eingerichtet, empfangene Signale auszuwerten. Eine derartige Elektronik und/oder eine derartige Empfangs- und/oder Auswerteinheit ist insbesondere nicht dazu eingerichtet, Signale zu senden bzw. die Antenne oder Antennenanordnung zum Senden von Signalen zu steuern.

Beispielsweise beim MRT dient die Antenne dem Empfang bzw. der Detektion von Magnetresonanz-Signalen, insbesondere durch Detektion einer in der Antenne induzierten elektrischen Spannung. Insbesondere ist die Antenne eine Hochfrequenzantenne, die mit einer Frequenz im Radiowellenbereich bzw. Radiofrequenzbereich, insbesondere im MHz-Bereich, arbeitet, bzw. für einen solchen Bereich ausgelegt ist. Zukünftige Anwendungen können auch im GHz-Bereich arbeiten. Die Antenne kann also typischerweise ein Hochfrequenzfeld detektieren. Sie kann auch als Radiofrequenz- bzw. RF-Antenne bezeichnet werden.

Das bildgebende Verfahren ist typischerweise ein diagnostisches und/oder medizinisches Verfahren. Es dient insbesondere dazu, Aufnahmen von einem Körper oder einem Teil eines Körpers eines Lebewesens, beispielsweise eines Menschen oder eines Tiers, zu machen, aus denen Informationen über einen Gesundheitszustand des Lebewesens abgeleitet werden können.

In einer Ausgestaltung umfasst die Antenne eine Schaltung, die einen Antennenanschluss mit einem ersten Leiter und einem zweiten Leiter umfasst. Insbesondere ist an dem ersten Leiter und/oder an dem zweiten Leiter ein weiteres elektrotechnisches Bauteil (konzentriertes Bauteil) angeschlossen.

In einer Ausgestaltung umfasst die Antenne einen Vorverstärker. Der Vorverstärker dient insbesondere dazu, empfangene Signale, insbesondere Magnetresonanzsignale, zu verstärken, bevor sie zu einer Empfangs- und/oder Auswerteinheit geleitet werden. Eine Antennenanordnung kann einen oder mehrere Vorverstärker aufweisen. Insbesondere umfasst die Antenne einen Anschluss zum Anschließen an eine Empfangs- und/oder Auswerteinheit. Der Anschluss kann mit dem Vorverstärker verbunden sein, insbesondere direkt.

In einer Ausführungsform ist die Antenne oder die Antennenanordnung zur Vorverstärkerentkopplung eingerichtet. Dabei kann eine hohe Impedanz an der Öffnung der Antenne vorliegen bzw. der oder die Vorverstärker können offene Eingänge aufweisen. So werden die Effekte der wechselseitigen Induktanz zwischen unterschiedlichen Antennen einer Antennenanordnung minimiert, was die Abstimmung und Anpassung erheblich erleichtert. Vorverstärker-Entkopplung wird grundsätzlich nur bei reinen Empfangsantennen eingesetzt. Dies erlaubt mehr Spielraum für die Verbesserung der Qualität der Antennenanordnung und ermöglicht eine dichtere Platzierung der einzelnen Antennen in der Antennenanordnung, insbesondere zusammen mit anderen Entkopplungsmethoden. Dies verbessert die Empfindlichkeit und den Beschleunigungsfaktor für die parallele Bildgebung.

Durch die Verwendung des Vorverstärkers bzw. die Vorverstärkerentkopplung kann beim Anpassen der Stromkreis beispielsweise hochohmig oder niedrigohmig gemacht werden, um den Stromfluss zu blockieren oder durchzulassen. Dies wird durch den Anpassungszustand bestimmt.

Insbesondere umfasst die Antenne eine Kabelfalle. Insbesondere ist die Kabelfalle mit einem Leiter des Antennenanschlusses verbunden, bevorzugt direkt. Die Kabelfalle ist insbesondere mit einem äußeren Leiter des Kabelanschlusses verbunden. Insbesondere umfasst die Antenne eine weitere Kapazität. Die weitere Kapazität kann mit der Kabelfalle verbunden sein, insbesondere direkt. Insbesondere umfasst die Antenne eine Erdung. Die Erdung kann mit der weiteren Kapazität verbunden sein, insbesondere direkt. Insbesondere ist der Vorverstärker, die Erdung, die weitere Kapazität und/oder die Kabelfalle mit einem bevorzugt äußeren Leiter des Antennenanschlusses verbunden. Insbesondere dient die Kabelfalle zur Entfernung von Gleichtaktstrom, der normalerweise auf der Oberfläche bzw. dem Außenleiter (Abschirmung/Masse) von Koaxialkabeln fließt und zu Störungen in benachbarten Kanälen führt. Insbesondere ist die Kabelfalle auf die Zielfrequenz abgestimmt. Insbesondere kann der Gleichtaktstrom auf dem Erdungspfad durch die Abfangspule (Kabel + Induktor) entfernt werden.

Insbesondere umfasst die Antenne eine weitere Induktivität. Die weitere Induktivität kann mit einem Leiter des Antennenanschlusses verbunden sein, insbesondere direkt. Insbesondere umfasst die Antenne eine weitere Kapazität. Die weitere Kapazität kann mit der weiteren Induktivität verbunden sein, insbesondere direkt. Der Vorverstärker kann mit der weiteren Kapazität verbunden sein, insbesondere direkt. Insbesondere ist der Vorverstärker, die weitere Kapazität und/oder die weitere Induktivität mit einem bevorzugt zentralen Leiter des Antennenanschlusses verbunden.

Insbesondere umfasst die Antenne einen Verstimmungsschalter, insbesondere mit einer PIN-Diode. Diese kann parallel zum Antennenanschluss angeordnet sein. Mittels jeweiliger RF-Drosseln können ein Gleichstromeingang und/oder ein Gleichstromausgang angeschlossen sein. Die PIN-Diode kann zum Verstimmen der Antenne dienen, insbesondere während des Sendens. Das Senden erfolgt, wie beschrieben, mit einer separaten Antenne. Die Antenne kann auch eine oder mehrere passiven Querdioden und/oder Induktoren bzw. Induktorsätze aufweisen. Die Verstimmung kann somit auch gemeinsam mit diesen sichergestellt werden.

In einer Ausgestaltung ist der die Kapazität eine variable Kapazität, insbesondere ein variabler Kondensator. Dementsprechend kann die Kapazität in einem bestimmten Bereich variabel angepasst werden.

Jedes zu messende Objekt, beispielsweise ein Körper oder Körperteil oder ein Phantom, benötigt eine bestimmte elektrische Kapazität. Die variable Kapazität gemäß dieser Ausgestaltung ermöglicht es, für jede durchzuführende Messung die geeignete elektrische Kapazität einzustellen. Es muss folglich kein Bauteil ausgetauscht werden, um die benötigte elektrische Kapazität zu erhalten. Die Kapazität kann in einem Beispiel in einem Bereich von wenigstens 0,1 pF, bevorzugt wenigstens 1 pF und/oder höchstens 100 pF, bevorzugt 10 pF, variabel sein.

In einer Ausgestaltung ist die Kapazität als Kapazitätsdiode ausgestaltet. Insbesondere kann auf diese Weise die elektrische Kapazität beeinflusst werden. Eine Kapazitätsdiode wird auch als Varicap oder Varaktor genannt. Durch Änderung einer angelegten Spannung kann die Kapazität variiert werden. Es kann auf einfache Weise die Kapazität elektrisch bzw. automatisch und ggf. aus der Ferne gesteuert bzw. geändert werden. So kann auf besonders einfache Weise die benötigte elektrische Kapazität eingestellt werden.

In einer Ausgestaltung weist der Speisungsabschnitt eine zweite Kapazität auf. Insbesondere dient die zweite Kapazität dazu, die Antenne anzupassen. Das Anpassen der Antenne kann dazu dienen, die Impedanz zwischen der Antenne und dem Ausgang des zur Speisung der Antenne vorgesehenen RF-Systems angepasst werden. Die Anpassung dient der Impedanzanpassung. Auf diese Weise können Strom bzw. Signale effizient und verlustarm übertragen werden. Die zweite Kapazität kann auf der Seite der Induktivität angeordnet sein. Die zweite Kapazität kann dem Antennenanschluss und/oder der Induktivität benachbart angeordnet sein.

Die Länge des Empfangsabschnitts beträgt in einer Ausführungsform $\frac{λ}{2}$, also die Hälfte der Wellenlänge. Die Länge des Empfangsabschnitts wird in Längsrichtung gemessen, insbesondere zwischen einem Anschluss des Speisungsabschnittes und der äußersten, gegenüberliegenden Stelle des Empfangsabschnitts. Bei einer Feldstärke von 7 T beträgt die halbe Wellenlänge ca. 50 cm. Dies kann z. B. zur Untersuchung des menschlichen Körpers eine geeignete Größe sein.

In einer Ausgestaltung weist der Speisungsabschnitt eine zweite Induktivität auf. Insbesondere kann so eine Verkürzung des Empfangsabschnitts der Antenne ermöglicht werden. So kann beispielsweise eine Untersuchung von kleineren Körperteilen oder Tieren mit derselben hohen Feldstärke ermöglicht werden.

Um die Antenne bei gleicher Frequenz kürzer ausführen zu können als die halbe Wellenlänge, kann eine zweite Induktivität verwendet werden. Die zweite Induktivität ist insbesondere unmittelbar oder mittelbar benachbart zum ersten Anschluss angeordnet. Die zweite Induktivität ist insbesondere unmittelbar oder mittelbar benachbart zum Abzweig zum ersten Anschluss angeordnet. Die Induktivität, die zweite Induktivität und/oder eine etwaige Zusatzinduktivität kann beispielsweise eine Spule sein oder eine mäanderförmige oder ähnliche Struktur aufweisen.

Alternativ oder ergänzend kann der Speisungsabschnitt eine weitere Kapazität aufweisen, um eine Verlängerung des Empfangsabschnittes der Antenne zu ermöglichen. Eine Kombination von einer oder mehreren weiteren Kapazitäten und einer oder mehreren zweiten Induktivitäten kann vorgesehen sein, um die jeweiligen Bauteile wahlweise zu schalten, beispielsweise mit einem elektrischen Schalter wie einer PIN-Diode.

Eine Induktivität, zweite Induktivität und/oder Zusatzinduktivität kann der Abstimmung der Antenne dienen. Es kann damit für den konkreten Anwendungsfall eine besser abgestimmte Antenne bereitgestellt werden. Beispielsweise kann auf eine gewünschte Frequenz abgestimmt werden und/oder die Antenne kann auf eine andere magnetische Feldstärke eines anderen MRT-Systems abgestimmt werden. Die Länge des Empfangsabschnitts hat maßgeblichen Einfluss auf die Abstimmung.

Durch eine Abstimmung wird die Antenne auf die gewünschte Resonanzfrequenz abgestimmt. Sowohl Abstimmung als auch Anpassung beeinflussen den Leistungs- oder Signalempfang und ihre Effizienz hängt vom Zustand der Abstimmung/Anpassung ab. Die Effizienz ist maximal, wenn die Antenne bzw. die Antennen korrekt abgestimmt und angepasst sind.

Diese Ausgestaltung bringt den Vorteil mit sich, dass eine größere Flexibilität der Antenne erreicht wird. Eine Antenne kann in Abhängigkeit der jeweiligen Anforderungen, beispielsweise räumlicher oder geometrischer Anforderungen des Messgeräts, hinsichtlich ihrer Länge angepasst werden. Es muss keine neue Auslegung des Speisungsabschnitts erfolgen, sondern es kann auf einfache Weise eine geeignete zweite Induktivität angeordnet werden, um die fehlende geometrische Länge der Antenne bzw. des Empfangsabschnitts auf elektrische Weise auszugleichen. Es wird somit eine besonders flexible Antenne bereitgestellt. Insbesondere im Vergleich zu der bereits vorteilhaften J-Pol-Antenne wird so eine erhöhte Flexibilität erreicht. Es können Anpassungen an die jeweiligen Gegebenheiten erfolgen, beispielsweise an den Verwendungszweck, die Feldstärke und die Ziel-Abbildungsfläche. Es können dadurch auf der Basis eines einzigen Antennendesigns unterschiedlichste Antennenanordnungen hergestellt werden.

In einer Ausgestaltung weist der Speisungsabschnitt eine oder mehrere selektiv aktivierbare Zusatzinduktivitäten auf. Eine Zusatzinduktivität kann als Spule realisiert sein. Selektiv aktivierbar bedeutet, dass die Zusatzinduktivitäten geschaltet werden können, um wahlweise von einem Strom der Antenne durchflossen zu werden oder nicht. Sie sind also wahlweise aktiv oder nicht aktiv. Im aktiven Zustand wirken sie als Induktivität und beeinflussen somit die Induktivität der Antenne. Im inaktiven Zustand haben sie typischerweise keinen Effekt auf den Stromkreis des Speisungsabschnitts. Eine Zusatzinduktivität kann auch vorhanden sein, wenn keine zweite Induktivität vorhanden ist.

Es können eine oder mehrere Zusatzinduktivitäten vorhanden sein. In einem Ausführungsbeispiel sind eine oder mehrere Zusatzinduktivitäten vorhanden, die parallel zu der Induktivität und/oder der zweiten Induktivität geschaltet sind. In einem Ausführungsbeispiel sind eine oder mehrere Zusatzinduktivitäten vorhanden, die in Reihe mit der Induktivität und/oder der zweiten Induktivität geschaltet sind. Die jeweiligen elektrischen Induktivitäten können nach den bekannten Regeln ermittelt werden.

Insbesondere ist eine Zusatzinduktivität vorhanden, um eine gewünschte Verkürzung des Empfangsabschnitts zu ermöglichen. Es sind je nach aktiviertem oder inaktiviertem Zustand der Zusatzinduktivität dann zwei unterschiedliche Längen des Empfangsabschnitts möglich. Bei mehr als einer Zusatzinduktivität können entsprechend mehr unterschiedliche Längen realisiert werden. Unterschiedliche Kombinationen unterschiedlicher Teilstromkreise mit jeweiligen Zusatzinduktivitäten ermöglichen weitere Längen.

Insbesondere weist der Speisungsabschnitt einen elektrischen Schalter wie z. B. eine PIN-Diode zum Aktivieren einer oder mehrerer Zusatzinduktivitäten auf. Der elektrische Schalter bzw. die PIN-Diode ist bevorzugt nicht magnetisch. Alternativ kann ein MEMS-Schalter oder ein beliebiger anderer MR-kompatibler Schalter verwendet werden. Auf diese Weise kann ein Aktivieren und Deaktivieren auf einfache Weise elektrisch und ggf. aus der Ferne gesteuert werden. Eine PIN-Diode ist besonders geeignet und kann einfach und kostengünstig vorgesehen werden. Insbesondere ist für jede Zusatzinduktivität und/oder für jede Gruppe von Zusatzinduktivitäten ein elektrischer Schalter vorhanden.

In einer Ausgestaltung weist der Speisungsabschnitt einen elektrischen Schalter wie z. B. eine PIN-Diode zum Ein- und Ausschalten der Antenne auf. Alternativ kann ein MEMS-Schalter oder ein beliebiger anderer MR-kompatibler Schalter verwendet werden. Auf diese Weise kann der Stromfluss durch den Speisungsabschnitt aktiviert oder deaktiviert und auf diese Weise die Antenne ein- oder ausgeschaltet werden. Insbesondere ist der elektrische Schalter so angeordnet, dass er den Stromkreis des Speisungsabschnitts unterbricht. Demnach ist der elektrische Schalter typischerweise in Reihe mit dem Antennenanschluss, der Kapazität, der Induktivität und/oder dem Abzweig zum ersten Schalter geschaltet.

In einer Ausgestaltung ist die Antenne oder eine zugehörige Antennenanordnung eine Antenne bzw. Antennenanordnung für Magnetresonanztomographie (MRT), Ultrahochfeld-MRT, Magnetresonanzspektroskopie (MRS), insbesondere simultane Positronen-Emissions-Tomographie-MRT (PET-MRT) und/oder ein Magnetresonanz-basiertes Hybridverfahren. Alternativ oder ergänzend kann die Antenne eine Antenne für MR-Einzelprotonen-Emissions-Computertomographie (MR-SPECT), MR-Linac (Linearbeschleuniger kombiniert mit einem Magnet-Resonanz-Tomographen) und/oder MR-gestützter Ultraschall (engl.: *MR-guided Ultrasound*) sein. In einer Konfiguration ist die Antennenanordnung eine Antennenanordnung für eine Kombination aus zwei oder mehr der genannten Verfahren.

PET und SPECT sind Verfahren, bei denen radioaktive Tracer verwendet werden, um bestimmte Stoffwechselprozesse und/oder Molekularwege sichtbar zu machen. Die Tracer werden in Körpergeweben auf der Grundlage ihrer biochemischen Funktion lokalisiert. Bei der PET-Bildgebung führt eine Positronenemission zur Erzeugung von zwei Gammaphotonen, die sich in entgegengesetzter Richtung entlang einer Gerade bewegen. Ein PET-Scanner, der beispielsweise mit ringförmig angeordneten Detektoren ausgestattet ist, kann diese Protonen einfangen, um Bilder zu erzeugen. Im Falle der SPECT-Bildgebung bewegen sich die emittierten Gammaphotonen entlang einer Geraden. Ein SPECR-Scanner, der beispielsweise mit Detektoren ausstattet ist, die etwa in einem vollständigen Ring oder in einer rotierenden Baugruppe, etwa einem Panel, angeordnet sind, erfasst die Photonen, um Bilder zu erzeugen. Auf diese Weise können mit einem hohen Maß an Spezifität und Empfindlichkeit Einblicke in physiologische und metabolische Prozesse erhalten werden. Erfindungsgemäß kann die Antennenanordnung für eine Kombination dieser Verfahren mit MR verwendet werden. MR-PET kombiniert etwa die Stärken beider Verfahren und ermöglicht so strukturelle und funktionelle molekulare Bildgebung. Dies gilt analog für MR-SPECT. Bei MR-PET oder MR-SPECT muss eine MRT-(Hochfrequenz)-Antenne im Sichtfeld (FOV) des PET- oder SPECT-Scanners positioniert werden. Bisherige (HF-)Antennen sind nicht für SPECT oder PET optimiert und enthalten Kondensatoren, Induktivitäten, Kabel, usw., die Signale abschwächen und ungleichmäßig streuen. Das führt zu Artefakten und einer geringeren Empfindlichkeit der PET- und SPECT-Bilder. Auch nach einer Korrektur bleiben Artefakte üblicherweise sichtbar. Auch das Signal-Rausch-Verhältnis von SPECT und PET ist reduziert, weil die Nachweisempfindlichkeit durch diese Abschwächung verringert ist. In einer Ausführungsform ist die Antenne mit X-Kernen wie 19F kombinierbar oder kombiniert.

In einer Ausgestaltung ist der Empfangsabschnitt der Antenne aus einem im Wesentlichen PET- und/oder SPECT-transparenten Material, beispielsweise Kupfer oder Aluminium, hergestellt. Im Wesentlichen PET- und/oder SPECT-transparente Materialien bringen beim PET bzw. SPECT eine geringe bis vernachlässigbare Dämpfung und Streuung mit sich. Insbesondere ist das im Wesentlichen PET- und/oder SPECT-transparente Material ein Metall mit einer niedrigen Ordnungszahl. Kupfer und Aluminium sind besonders gut als Material des Empfangsabschnitts geeignet, aber es können auch andere Materiale verwendet werden. Auf diese Weise kann die Antenne wie beschrieben in Tomographiesystemen für simultane MR-PET/-SPECT verwendet werden. In einer Ausführungsform ist der Empfangsabschnitt der Antenne aus einem MR-kompatiblen, gegenüber Gammastrahlen im Wesentlichen transparenten und/oder Gammaphotonen nur minimal streuenden Material hergestellt.

Der Empfangsabschnitt ist insbesondere ein einseitig angeschlossener elektrischer Leiter. Die Länge des Empfangsabschnitts ist typischerweise um wenigstens den Faktor 5, insbesondere wenigstens den Faktor 10 länger als die Höhe und die Breite des Empfangsabschnitts, also als die Erstreckungen in den zwei Ausdehnungsrichtungen quer zur Längserstreckung. In einer Ausführungsform ist der Empfangsabschnitt der Antenne sehr dünn. Sehr dünn bedeutet insbesondere, dass der Empfangsabschnitt höchstens um einen Faktor von 3 bis 5 dicker ist als die Hauttiefe bei der gewünschten Frequenz. Der Empfangsabschnitt kann beispielsweise ein Draht sein. eine dünne Ausführung ist besonders vorteilhaft in hybriden Systemen wie MR-PET oder MR-SPECT. Bei reinen MR-Systemen kann auch ein dickerer Empfangsabschnitt vorgesehen sein, beispielsweise in Form eines Koaxialkabels.

Ein weiterer Aspekt der Erfindung ist eine Antennenanordnung für ein bildgebendes Verfahren. Die Antennenanordnung umfasst mindestens eine oder mindestens zwei erfindungsgemäße Antennen. Alle Merkmale, Ausgestaltungen und Vorteile der eingangs beschriebenen Antenne gelten ebenso für die Antennenanordnung und umgekehrt.

Insbesondere enthält die Antennenanordnung mindestens 2, bevorzugt mindestens 4 oder 8 und/oder höchstens 256, insbesondere höchstens 128 Antennen, bevorzugt mindestens 32 und/oder höchstens 64 Antennen.

Je nach gewünschter Frequenz und Zielobjekt können die Längen durch das Vorsehen einer zweiten Induktivität und/oder einer oder mehrerer Zusatzinduktivitäten wie oben beschrieben angepasst, verkürzt oder verlängert werden.

In einer Ausführungsform umfasst die Antennenanordnung eine Positionierungseinheit zur Positionierung der Antennen in Bezug zueinander und/oder zu einem zu untersuchenden Körper. Zur Anpassung an die Form und/oder Größe des zu untersuchenden Körpers oder Körperteils kann die Positionierungseinheit an die Form und/oder Größe des zu untersuchenden Körpers oder Körperteils angepasst sein. Die Positionierungseinheit kann räumlich an die Antennen angepasst sein, beispielsweise an unterschiedlich lange oder unterschiedliche Anzahlen von Antennen, wie unten beschrieben. Die Positionierungseinheit kann als Halteeinrichtung zum Halten der Empfangsantennen ausgestaltet sein. Sie kann zur fixen Positionierung der Empfangsantennen aneinander bzw. in Bezug zueinander ausgestaltet sein. Sie kann ein fester Gegenstand sein, der an einem Körper oder Körperteil angeordnet werden kann bzw. in den ein Teil eines Körpers eingebracht werden kann. Die Positionierungseinheit kann als Befestigungseinheit zur mechanischen Befestigung der Empfangsantennen aneinander ausgestaltet sein. Insbesondere sind die Empfangsantennen nebeneinander angeordnet.

In einer Ausgestaltung weisen mindestens zwei Antennen der Antennenanordnung gleich lange oder unterschiedlich lange Empfangsabschnitte auf. Typischerweise sind die Empfangsabschnitte parallel zueinander angeordnet. Die Speisungsabschnitte der mindestens zwei Antennen können in einer gemeinsamen Ebene angeordnet sein. Die Speisungsabschnitte der mindestens zwei Antennen können in einem gemeinsamen Speisungsteil angeordnet sein. Die Empfangsabschnitte können sich dementsprechend von den Speisungsabschnitten ausgehend unterschiedlich weit erstrecken. Auf diese Weise können räumlich bzw. geometrisch angepasste Antennenanordnungen hergestellt werden. Das Sichtfeld kann geometrisch angepasst werden. Beispielsweise kann der sensitive Bereich in der Nasenhöhlenregion im Bereich der Nase des Patienten, der Artefakte erzeugen und die MR-Bildqualität verschlechtern kann, reduziert oder entfernt werden und/oder es kann ein besonderer Fokus auf das Gehirn des Patienten gelegt werden. Zudem kann die Zugänglichkeit und damit der Komfort bei der Benutzung des Systems verbessert werden, etwa durch geeignete Aussparungen. Zudem können Blockierungen verhindert und/oder das B1-Feld angepasst werden.

In einer Ausgestaltung weist die Antennenanordnung einen Empfangsteil auf, wobei die Empfangsabschnitte der Antennen im Empfangsteil angeordnet sind. In einer Ausgestaltung weist die Antennenanordnung einen Speisungsteil auf, wobei die Speisungsabschnitte der Antennen im Speisungsteil angeordnet sind. Der Speisungsteil kann dem Empfangsteil benachbart angeordnet sein.

Die gesamte Antennenanordnung kann in zwei separate, räumlich getrennte Teile unterteilt sein, einen Empfangsteil und einen Speisungsteil. Der Speisungsteil umfasst typischerweise sämtliche Speisungsabschnitte und/oder im Empfangsteil sind keine Speisungsabschnitte vorhanden. Der Empfangsteil umfasst typischerweise sämtliche Empfangsabschnitte und/oder im Speisungsteil sind keine Empfangsabschnitte vorhanden. Der Empfangsteil kann demnach im Messbereich des Tomographiesystems angeordnet sein. So ist es möglich, dass im Messbereich keine Speisungsabschnitte und damit keine Bauteile mit hoher Dichte wie z. B. Kondensatoren angeordnet sind. Dies reduziert im Falle von PET und/oder SPECT Artefakte aufgrund der Bauelemente und ermöglicht eine wesentlich höhere Qualität bei der Bildgebung.

Insbesondere definieren die Antennen der Antennenanordnung einen Hohlkörper, in dem ein Körper oder ein Körperteil angeordnet werden kann. Dier Antennen sind um den Hohlkörper herum angeordnet, insbesondere gleichmäßig verteilt. Insbesondere sind die Empfangsteile der Antennen um den Hohlkörper herum angeordnet und/oder definieren den Hohlkörper. So kann ein menschlicher oder tierischer Körper bzw. ein Teil davon in den Hohlkörper aufgenommen werden und dort bestrahlt werden.

Insbesondere weist der Hohlkörper eine kreiszylindrische Grundform auf. In diesem Fall können die Antennen in Blickrichtung entlang der Mittelachse der Grundform beispielsweise in einem regelmäßigen Vieleck angeordnet sein, etwa einem regelmäßigen Sechseck, Achteck oder Zwölfeck. Grundform bedeutet, dass Teile des Hohlkörpers oder der Antennenanordnung von der kreiszylindrischen Form abweichen können. Die tatsächliche Form des Hohlkörpers muss nicht exakt ein Kreiszylinder sein.

In einer Ausgestaltung sind die Empfangsabschnitte von mindestens zwei Antennen einander kreuzend angeordnet, insbesondere um eine zusätzliche Entkopplung zwischen en Antennen zu ermöglichen. Das bedeutet, dass sich die Empfangsabschnitte in zumindest einer Blickrichtung überkreuzen (ein Kreuz bilden). Dabei bilden die Empfangsabschnitte einen Winkel α zueinander aus, der ungleich null ist. Der Winkel α kann zwischen 30° und 90°, insbesondere zwischen 45° und 90° betragen. Die Antennenanordnung kann mehrere Paare aus jeweils zwei einander kreuzend angeordneten Antennen aufweisen.

Durch die einander kreuzende Anordnung der Empfangsabschnitte wird eine noch effektivere elektromagnetische Entkopplung der beiden Antennen voneinander erreicht. Es kann also eine noch weitergehende Entkopplung und/oder eine noch dichtere Anordnung der Antennen erreicht werden.

Ein weiterer Aspekt der Erfindung ist ein Verfahren zum Betreiben einer erfindungsgemäßen Antenne, bei dem mittels des Verstimmungsschalters (39), insbesondere der PIN-Diode (38), eine Verstimmung der Antenne geschaltet wird.. Auf diese Weise kann die Verstimmung geändert werden, insbesondere während des Sendens. Alle Merkmale, Ausgestaltungen und Vorteile der eingangs beschriebenen Antenne sowie der Antennenanordnung gelten ebenso für das Verfahren und umgekehrt.

Ein weiterer Aspekt der Erfindung ist ein Tomographiesystem, insbesondere für Magnetresonanztomographie (MRT) oder simultane Positronen-Emissions-Tomographie-MRT (PET-MRT). Das Tomographiesystem umfasst eine erfindungsgemäße Antenne oder eine erfindungsgemäße Antennenanordnung. Insbesondere sind Antennen des Tomographiesystems so angeordnet, dass sich die Speisungsabschnitte außerhalb eines Messbereichs des Tomographiesystems befinden. Alle Merkmale, Ausgestaltungen und Vorteile der eingangs beschriebenen Antenne, der Antennenanordnung sowie des Verfahrens gelten ebenso für das Tomographiesystem und umgekehrt.

Nachfolgend werden weitere Ausführungsbeispiele der Erfindung auch anhand von Figuren näher erläutert.

Es zeigen:
- Figuren 1 bis 7:: unterschiedliche nicht erfindungsgemäße Antennen;
- Figuren 8 und 9:: erfindungsgemäße Antennenanordnungen;
- Figur 10:: eine schematische Darstellung der Verwendung einer Antennenanordnung,
- Figuren 11 bis 17:: erfindungsgemäße Antennen,
- Figuren 18 bis 21:: weitere erfindungsgemäße Antennenanordnungen,
- Figur 22:: eine Zeichnung einer erfindungsgemäßen Antenne,
- Figur 23:: eine Zeichnung einer weiteren erfindungsgemäßen Antennenanordnung,
- Figur 24:: eine weitere schematische Darstellung der Verwendung einer Antennenanordnung, sowie
- Figuren 25 bis 28:: weitere erfindungsgemäße Antennen.

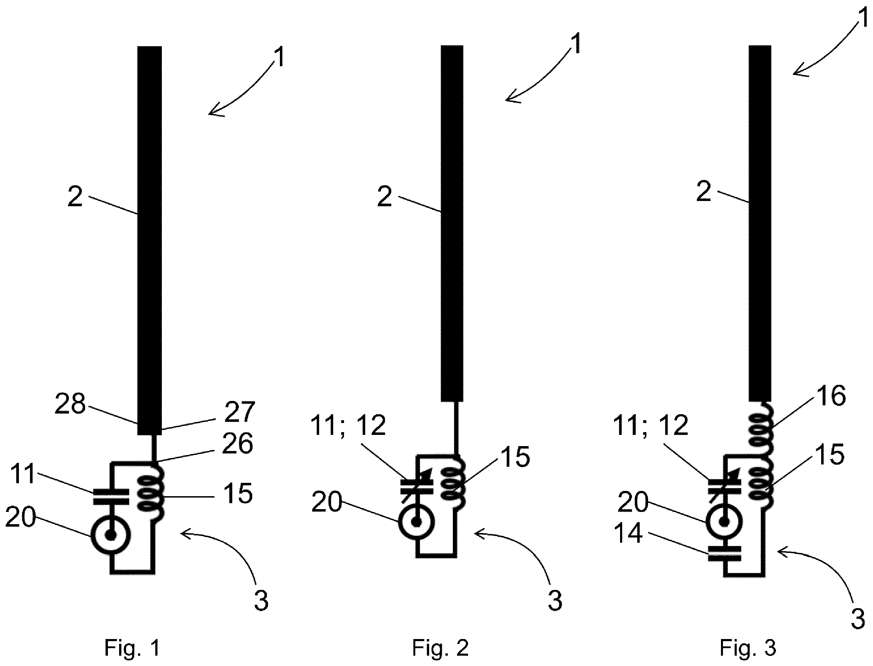

Figur 1 zeigt eine Antenne 1 für ein bildgebendes Verfahren, die nicht gemäß der Erfindung ausgestaltet ist, da es sich um eine kombinierte Sende- und Empfangsantenne handelt. Diese umfasst einen geraden Empfangsabschnitt 2 sowie einen unmittelbar daran anschließenden Speisungsabschnitt 3. Der Empfangsabschnitt 2 ist ein kombinierter Sende- und Empfangsabschnitt und kann auch als Strahlungsabschnitt bezeichnet werden. Der Empfangsabschnitt 2 ist beispielsweise als einseitig angeschlossener, elektrischer Leiter aus Kupfer oder Aluminium ausgestaltet. Grundsätzlich weist der Speisungsabschnitt 3 einen ersten Anschluss 27 auf, der mit einem zweiten Anschluss 28 des Empfangsabschnitts 2 elektrisch verbunden ist. So kann der Speisungsabschnitt 3 den Empfangsabschnitt 2 speisen. Die Verbindung ist im dargestellten Beispiel einstückig und nicht zerstörungsfrei lösbar. Der Speisungsabschnitt 3 weist zudem einen Antennenanschluss 20 auf, an dem beispielsweise ein Koaxialkabel zur Speisung der Antenne angeschlossen werden kann. Hierbei kann am zentralen Leiter das Signal anliegen, während die außenliegende Abschirmung geerdet ist.

Der Antennenanschluss 20 ist Teil eines elektrischen Stromkreises des Speisungsabschnitts 3. Der Speisungsabschnitt 3 umfasst ferner eine Kapazität 11 sowie eine Induktivität 15. Es konnte gezeigt werden, dass mit dieser einfachen und platzsparenden Schaltung das Verhalten einer J-Pol-Antenne erreicht werden kann. Der Stromkreis ist am Abzweig 26 mit dem ersten Anschluss 27 des Speisungsabschnitts verbunden. Bei der Verwendung kleiner Komponenten kann der Speisungsabschnitt 3 extrem klein hergestellt werden.

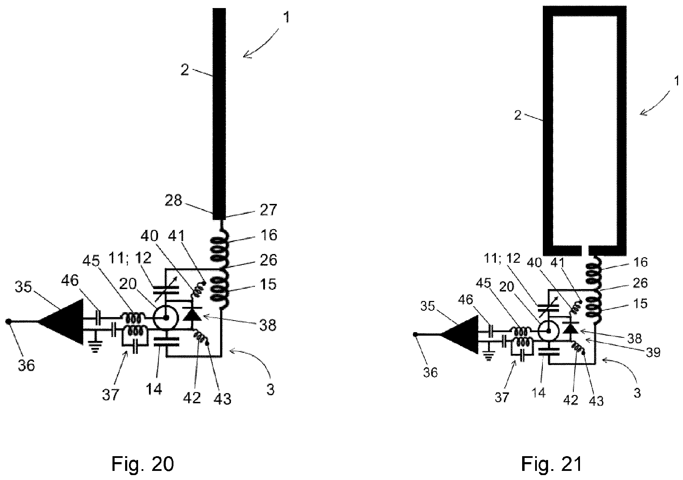

Auch die Figuren 2 bis 7 zeigen kombinierte Sende- und Empfangsantennen, die also nicht erfindungsgemäß sind. Auch hier dienen die Empfangsabschnitte 2 sowohl dem Senden als auch dem Empfangen von Signalen. Die Figuren 1 bis 7 zeigen unterschiedliche Varianten des Speisungsabschnitts 3, genauer gesagt von elektrischen Schaltungen, die in die erfindungsgemäße Antenne integriert werden können. Zu diesem Zweck kann z. B. der links dargestellte Teil des Speisungsabschnitts 3 aus Figur 20 in die hier gezeigten Schaltungen integriert werden, z. B. an den Antennenanschluss 20 angeschlossen werden. Der links dargestellte Teil kann die Bauteile mit den Bezugszeichen 36, 35, 46, 45, 37, 38, 40, 41, 42, und/oder 43 umfassen. Die Integration kann dadurch erfolgen, dass elektrische Leitungen, die zur Kabelfalle 37 führen, an die zwei Leiter des Antennenanschlusses angeschlossen werden und/oder dass die PIN-Diode 38 an die zwei Leiter des Antennenanschlusses angeschlossen werden.

Figur 2 zeigt ein weiteres Ausführungsbeispiel basierend auf der Antenne 1 aus Figur 1. Abweichend von Figur 1 ist lediglich, dass die Kapazität 11 als variable Kapazität 12 ausgestaltet ist.

Figur 3 zeigt ein weiteres Ausführungsbeispiel basierend auf der Antenne 1 aus Figur 2. Zusätzlich zu der Antenne 1 aus Figur 2 umfasst die hier gezeigte Antenne 1 eine zweite Kapazität 14, um die Antenne anzupassen. Selbstverständlich kann eine Antenne mit einer zweiten Kapazität 14 auch mit einer festen Kapazität 11 gemäß Figur 1 ausgestattet sein.

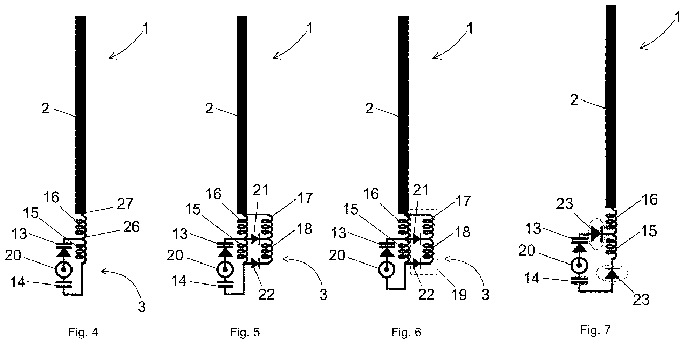

Figur 4 zeigt ein weiteres Ausführungsbeispiel basierend auf der Antenne 1 aus Figur 3. Anstelle der variablen Kapazität umfasst die hier gezeigte Antenne eine Kapazitätsdiode 13, die ein automatisches Einstellen der elektrischen Kapazität erlaubt. Zudem umfasst die Antenne aus Figur 4 eine zweite Induktivität 16, die zwischen dem Abzweig 26 und dem ersten Anschluss 27 angeordnet ist. Diese erlaubt die Einstellung eines anderen, insbesondere kürzeren Empfangsabschnitts 2. Selbstverständlich kann eine Antenne mit einer zweiten Induktivität 16 auch mit einer festen Kapazität 11 gemäß Figur 1, einer variablen Kapazität 12 gemäß Figur 2 und/oder ohne eine zweite Kapazität 14 wie in den Figuren 1 und 2 ausgestattet sein.

Figur 5 zeigt ein weiteres Ausführungsbeispiel basierend auf der Antenne 1 aus Figur 4. Zusätzlich zur in Figur 4 gezeigten Antenne 1 weist die Antenne 1 aus Figur 5 zwei Zusatzinduktivitäten 17, 18 auf, die mit jeweiligen PIN-Dioden 21, 22 selektiv aktivierbar sind. Die Zusatzinduktivitäten sind miteinander in Reihe und parallel zu der Induktivität 15 und der zweiten Induktivität 16 geschaltet. So kann die Gesamtinduktivität wahlweise eingestellt werden, um eine bestimmte Länge des Empfangsabschnitts 2 zu verwenden. Der hier gezeigte Antenne 1 ist elektrisch einstellbar und abstimmbar. Dies ist aus der Ferne möglich. Auch Figur 5 zeigt nur ein Beispiel, dessen Bauteile beliebig kombiniert werden können. So kann eine Antenne mit einer oder zwei Zusatzinduktivitäten 17, 18 auch ohne zweite Induktivität 16, ohne zweite Kapazität 14 und/oder mit einer fixen Kapazität 11 oder variablen Kapazität 12 ausgestattet sein.

Figur 6 zeigt die Antenne 1 aus Figur 5 ohne zweite Kapazität 14. Zudem ist die Baueinheit 19, die die Zusatzinduktivitäten 17, 18 umfasst, mit einer gestrichelten Linie hervorgehoben. Rechts davon können eine oder mehrere weitere Baueinheiten 19 angeordnet werden, um weitere, variabel aktivierbare Zusatzinduktivitäten vorzusehen. So kann die Antenne 1 für eine Vielzahl unterschiedlicher Längen des Empfangsabschnitts 2 eingestellt werden.

Figur 7 zeigt eine Ausführungsform basierend auf der Antenne 1 aus Figur 4. Zusätzlich zu den in Figur 4 gezeigten und oben beschriebenen Komponenten weist die Antenne 1 aus Figur 7 zwei elektrische Schalter in Form von PIN-Dioden 23 auf, um den Stromkreis des Speisungsabschnitts zu unterbrechen. Die PIN-Dioden 23 sind in gepunkteten Linien dargestellt. Dies soll zeigen, dass hier beispielhafte Positionen dargestellt sind. Grundsätzlich reicht eine PIN-Diode zum Unterbrechen des Stromkreises aus. Diese kann an einer der dargestellten Positionen oder an einer anderen Position angeordnet sein. Selbstverständlich könnte jede der in den Figuren 1 bis 6 gezeigten und/oder davon abweichenden, oben beschriebenen Antennen 1 an beliebiger Stelle im Stromkreis eine PIN-Diode gemäß Figur 7 aufweisen.

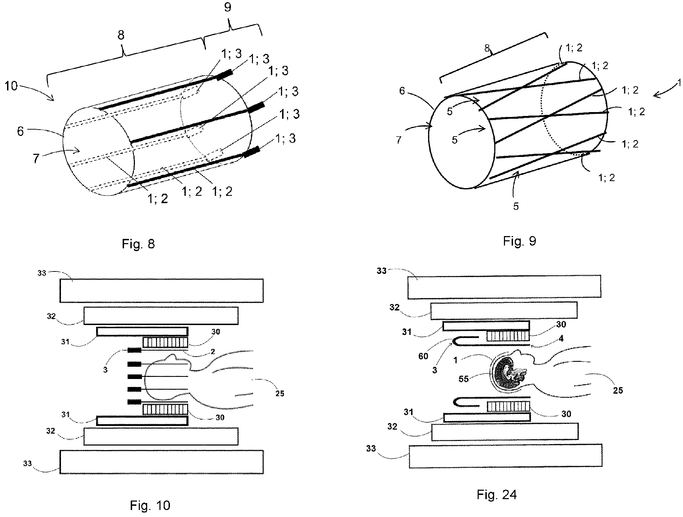

Figur 8 zeigt eine Antennenanordnung 10. Hierbei können typischerweise parallel angeordnete Antennen 1 so angeordnet sein, dass sie einen Hohlkörper 6 umgeben. Die Antennen 1 sind so angeordnet, dass ihre Empfangsabschnitte 2 den Hohlkörper 6 umgeben. Der Hohlkörper 6 hat z. B. eine kreiszylindrische Grundform 7. In den Hohlkörper 6 kann ein Körperteil oder ein Körper aufgenommen werden, um mit dem bildgebenden Verfahren untersucht zu werden. Die verdeckten Antennen 1 sind gestrichelt dargestellt. Aus Gründen der Übersichtlichkeit sind lediglich sechs Antennen 1 dargestellt. Insgesamt können hier aber beispielsweise 12, 16, 24 oder 32 Antennen 1 vorhanden sein.

Beispielsweise werden die einzelnen Antennen nicht, wie in herkömmlichen Anordnungen, alle gleich gespeist, sondern können einzeln gesteuert werden. So kann eine verbesserte Entkopplung erreicht werden. Typischerweise sind alle Antennen einer Antennenanordnung auf dieselbe Frequenz abgestimmt.

Die Empfangsabschnitte 2 der Antennen 1 bilden gemeinsam einen Empfangsteil 8 der Antennenanordnung 10. Die Speisungsabschnitte 3 der Antennen 1 bilden gemeinsam einen Speisungsteil 9, der am rechten Ende des Empfangsteils 8 und damit des Hohlkörpers 6 angeordnet sein kann und bevorzugt unmittelbar an den Empfangsteil 8 anschließt. Bevorzugt weisen die Antennen 1 dementsprechend alle dieselbe Ausrichtung auf. Empfangsteil 8 und Speisungsteil 9 sind räumlich voneinander getrennt, sodass der Empfangsteil 8 im Messbereich des Tomographiesystems und der Speisungsteil 9 außerhalb des Messbereichs angeordnet sein kann. So wird verhindert, dass sich konzentrierte Bauteile wie Kondensatoren im PET- oder SPECT-Sichtfeld befinden. Lediglich ein dünnes Leitermuster ist dann im Sichtfeld vorhanden. So wird gewährleistet, dass nur minimale Dämpfung und Streuung erfolgen, die für die PET- bzw. SPECT-Bildgebung vernachlässigbar sind. Dieses Prinzip kann mit allen gezeigten und/oder beschriebenen Ausführungen der Antenne kombiniert werden.

Abweichend von der in Figur 8 gezeigten Ausführung, bei der die Empfangsabschnitte 2 geradlinig ausgeführt sind, können bevorzugt gekrümmte oder anders geformte Empfangsabschnitte 2 bzw. Leiter verwendet werden. die ermöglicht, die Antenne an die Form des Untersuchungsobjekts anzupassen. Im Falle eines Kopfes können so die Empfangsabschnitte 2 z. B. an die Krümmung des Kopfes angepasst werden.

Figur 9 zeigt eine weitere Antennenanordnung 10 basierend auf der Antennenanordnung aus Figur 8. Aus Gründen der Übersichtlichkeit wird hier nur auf die Unterschiede eingegangen. Abweichend von Figur 8 sind hier Paare 5 benachbarter Antennen 1 jeweils einander überkreuzend angeordnet. Auf diese Weise kann eine noch weitergehende Entkopplung der einzelnen Antennen 1 erreicht werden.

Die Speisungsabschnitte der Antennen 1 sind aus Gründen der Übersichtlichkeit in Figur 9 nicht dargestellt. Insbesondere bilden die Speisungsabschnitte der Antennen 1 wie in Figur 8 gemeinsam einen Speisungsteil. Auch hier sind lediglich drei Paare 5 dargestellt; üblicherweise sind aber z. B. 6, 8, 10, 12, 14 oder 16 Paare vorhanden.

Figur 10 zeigt die Anwendung der erfindungsgemäßen Antenne mit Empfangsabschnitt 2 und Speisungsabschnitt 3 in einem Tomographiesystem. Die Antennen einer Antennenanordnung bilden einen Hohlkörper, beispielsweise wie in Figur 8, in dem der Kopf des Patienten 25 positioniert ist. Oberhalb und unterhalb des Kopfes befinden sich, von innen nach außen, ein PET-System 30, eine optionale Körperantenne 31, eine (Gradienten-)Ausgleichsspule 32 sowie die Magnete 33 für das starke Magnetfeld des MRT. Durch die gewählten Kupferleiter als Empfangsabschnitte 2 und die Konstruktion, bei der die Speisungsabschnitte 3 außerhalb des Sichtfeldes angeordnet sind, werden minimale Dämpfung und Streuung gewährleistet, so dass nur ein vernachlässigbarer Einfluss auf das PET auftritt. Somit ist das System kompatibel nicht nur mit MRT-Systemen, sondern auch mit hybriden MRT-PET/-SPECT-Systemen.

In einer Ausgestaltung weist der Antennenanschluss zwei Leiter auf. Insbesondere trägt ein erster Leiter, insbesondere ein zentraler Leiter, ein Signal. Insbesondere ist ein zweiter Leiter geerdet. Insbesondere ist ein erster Leiter mit der Kapazität verbunden. Insbesondere ist ein zweiter Leiter mit der Induktivität verbunden. Die Verbindung kann eine direkte oder indirekte Verbindung sein. Bei einer direkten Verbindung sind die jeweiligen Komponenten unmittelbar elektrisch miteinander verbunden, ohne dass andere Komponenten wie Abzweige oder elektrotechnische Bauteile bzw. konzentrierte Bauteile dazwischen vorhanden wären. Zwischen indirekt verbundenen Bauteilen ist mindestens eine weitere Komponente vorhanden. Beispielsweise kann eine Kapazität zwischen dem zweiten Leiter und der Induktivität angeordnet sein. Insbesondere ist der erste Leiter direkt mit der Kapazität verbunden. Insbesondere ist der erste Leiter mit der Kapazität in Reihe geschaltet. Insbesondere ist der zweite Leiter mit der Induktivität in Reihe geschaltet. Insbesondere ist eine Reihenschaltung vorhanden, bei der die Kapazität, mit dem Antennenanschluss und der Induktivität in dieser Reihenfolge in Reihe geschaltet ist. Zwischen dem Antennenanschluss und der Induktivität können sich dabei ein oder mehrere weitere Bauteile befinden.

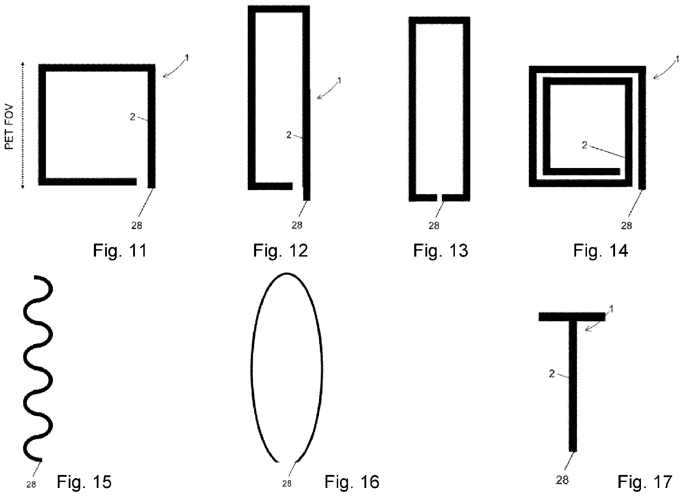

Die Figuren 11 bis 17 zeigen Empfangsabschnitte 2 weiterer erfindungsgemäßer Antennen 1, aus denen ersichtlich ist, dass die Größe und Form des Empfangsabschnitts 2 variabel gewählt werden kann, beispielsweise in Abhängigkeit der magnetischen Feldstärke und/oder des zu untersuchenden Körperteils. Es sind jeweils die Empfangsabschnitte 2 dargestellt, an deren zweiten Anschluss 28 jeweils ein Speisungsabschnitt angeschlossen ist oder wird (vergl. Fig. 1). Die Antennen 1 unterscheiden sich lediglich in der Größe und Form der Empfangsabschnitte 2. Der Speisungsabschnitt kann beispielsweise gemäß Figur 20 ausgestaltet sein. Es kann jedoch für jede der Figuren 11 bis 17 in beliebiger Kombination ebenso jeder beliebige andere erfindungsgemäße Speisungsabschnitt verwendet werden.

In einer Ausführungsform entspricht die Erstreckung des Empfangsabschnitts zumindest in einer Raumrichtung, insbesondere in mehreren oder allen Raumrichtungen, der Größe des Sichtfeldes PET FOV eines Systems zur Positronen-Emissions-Tomographie (PET), zum simultanen Positronen-Emissions-Tomographie-MRT (PET-MRT) und/oder MR-Einzelprotonen-Emissions-Computertomographie (MR-SPECT). In einer Ausführungsform ist der Empfangsabschnitt in zumindest einer Raumrichtung, insbesondere in mehreren oder allen Raumrichtungen, auf die Größe des Sichtfeldes PET FOV des PET-/PET-MRT-/SPECT-Systems limitiert. Der Empfangsabschnitt weist höchstens die Erstreckung des Sichtfeldes auf. Insbesondere befindet sich der Empfangsabschnitt im Sichtfeld und/oder ist dort positionierbar. Dies ist rein schematisch in Figur 11 angedeutet, kann jedoch ebenso für die Antennen jeder anderen Figuren gelten. Das PET-/SPECT-/PET-MRT-System sowie die Antenne können Teil eines erfindungsgemäßen Tomographiesystems sein.

In einer Ausführungsform sind zwei Antennen derart überlagert, dass ein Empfangsabschnitt einer ersten Antenne innerhalb des Empfangsabschnitts einer zweiten Antenne angeordnet ist.

Ein weiterer Aspekt der Erfindung ist eine Antennenanordnung für ein bildgebendes Verfahren. Die Antennenanordnung umfasst mindestens zwei Antennen, wobei mindestens eine Antenne eine erfindungsgemäße Antenne ist. Alle Merkmale, Ausgestaltungen und Vorteile der eingangs beschriebenen Antenne gelten ebenso für die Antennenanordnung und umgekehrt.

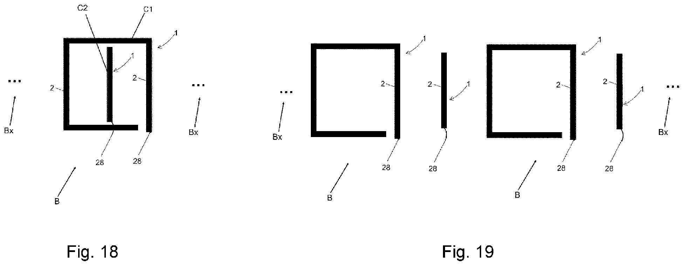

Figuren 18 und 19 zeigen schematisch erfindungsgemäße Antennenanordnungen. Wie in den Figuren 11 bis 17 sind von den Antennen 1 lediglich die Empfangsabschnitte 2 mit jeweiligen zweiten Anschlüssen 28 dargestellt, an die wiederum die Speisungsabschnitte angeschlossen werden können. Figur 18 zeigt eine Baugruppe B, die zwei Antennen 1 umfasst, die im Folgenden als Kanäle bezeichnet werden. Der Empfangsabschnitt 2 von Kanal 1 C1 ist als Rechteck, Quadrat und/oder gerundet ausgestaltet. Der Empfangsabschnitt 2 von Kanal 2 C2 ist beispielhaft gerade bzw. als Stab ausgeführt. Abweichend davon kann die Antenne des Kanals 1 C1 einen beliebig anders geformten, eine Fläche nach außen begrenzenden Empfangsabschnitt 2 aufweisen. Alternativ oder ergänzend kann die Antenne des Kanals 2 C2 eine beliebig anders geformten Empfangsabschnitt 2 aufweisen oder als J-Pol-Antenne und/oder ohne Induktivität ausgestaltet sein. Der Empfangsabschnitt 2 von Kanal 2 C2 befindet sich innerhalb des Empfangsabschnitt 2 von Kanal 1 C1. Rechts und links von der Baugruppe B sind weitere Baugruppen Bx durch Platzhalter angedeutet. Insbesondere sind diese analog zur Baugruppe B aufgebaut. Es können mehr als drei Baugruppen B vorhanden sein. Baugruppen können grundsätzlich beliebig im Raum angeordnet sein, beispielsweise verteilt und/oder gekrümmt um einen Innenraum herum angeordnet.

Figur 19 zeigt zwei Baugruppen B, die aus jeweils zwei nebeneinander angeordneten Antennen 1 bestehen. Es handelt sich hier wie in Figur 18 um eine Antenne mit rechteckigem oder quadratischem Empfangsabschnitt und um eine Antenne mit einem geraden Empfangsabschnitt 1. Auch hier können die Empfangsabschnitte 2 einer oder beider Antennen wie oben beschrieben alternativ geformt sein. Auch die Antennen 1 der Figuren 18 und 19 haben rein beispielhaft den Speisungsabschnitt 3 aus Figur 3 und können alternativ jeden beliebigen anderen erfindungsgemäßen Speisungsabschnitt 3 aufweisen. Rechts und links von der Baugruppe B sind auch hier weitere Baugruppen Bx durch Platzhalter angedeutet. Insbesondere sind diese analog zur Baugruppe B aufgebaut. Es können mehr als vier Baugruppen B vorhanden sein.

Figur 20 zeigt eine erfindungsgemäße Antenne 1. Der Speisungsabschnitt 3 der Antenne 1 ist im Vergleich zu den Figuren 1 bis 7 erweitert, um eine reine Empfangsantenne zu erhalten. Der Empfangsabschnitt 2 ist ein reiner Empfangsabschnitt, dient also ausschließlich dem Empfang von Signalen und nicht dem Senden von Signalen.

Der Speisungsabschnitt 3 kann einen Vorverstärker 35 umfassen, der mit einem Anschluss 36 zum Anschließen an eine Empfangs- und/oder Auswerteinheit verbunden sein kann. Der Vorverstärker kann über ein oder mehrere konzentrierte Bauteile mit dem Antennenanschluss 20 verbunden sein. Beispielsweise ist ein erster Leiter des Antennenanschlusses 20 - etwa wie gezeigt der zentrale Leiter - mit dem Vorverstärker 35 verbunden. Es kann zwischen dem ersten Antennenanschluss und dem Vorverstärker 35 eine Induktivität 45 und/oder eine Kapazität 46 angeordnet sein.

Beispielsweise ist ein zweiter Leiter des Antennenanschlusses 20 - etwa wie gezeigt der äußere Leiter - mit dem Vorverstärker 35 verbunden.

Es kann zwischen dem zweiten Leiter und dem Vorverstärker 35 eine Erdung und/oder einer Kabelfalle 37 angeordnet sein. Die Kabelfalle 37 kann für einen Leiter, insbesondere einen Außenleiter, eine Induktivität und/oder eine Kapazität umfassen, die parallel geschaltet sein können. Die Kabelfalle 37 kann für einen zweiten Leiter, insbesondere einen Innenleiter, die Induktivität 45 umfassen. Die Kabelfalle kann demnach die Merkmale umfassen, die durch die Bezugszeichen 37 und 45 repräsentiert sind. Die Kabelfalle 37 dient insbesondere zum Unterdrücken eines Stroms wie z. B. eines Gleichtaktstroms, der auf dem Außenleiter eines Koaxialkabels fließen kann. Die Kabelfalle kann auch als Balun bezeichnet werden. Die Induktivitäten der Kabelfalle 37 können durch Wickeln des Kabels, welches den Innenleiter und den Außenleiter umfasst, hergestellt worden sein. Das Wickeln kann in Form einer Spule mit einer oder mehreren Wicklungen bzw. Windungen erfolgen. Beide separat dargestellten Induktivitäten der Kabelfalle 37 liegen dann in einer gemeinsamen Einheit vor.

Der Speisungsabschnitt 3 kann eine PIN-Diode 38 umfassen, die insbesondere nicht magnetisch ist. Ein erster Kontakt der PIN-Diode 38 kann mit einem ersten Leiter des Antennenanschlusses 20 verbunden sein. An einer ersten Seite der PIN-Diode 38, beispielsweise die Seite des ersten Kontakts, kann eine HF-Drossel 40 angeschlossen sein. An der HF-Drossel 40 kann ein Gleichstromausgang 41 angeschlossen sein. Ein zweiter Kontakt der PIN-Diode 38 kann mit einem zweiten Leiter des Antennenanschlusses 20 verbunden sein. An einer zweiten Seite der PIN-Diode 38, beispielsweise die Seite des zweiten Kontakts, kann eine HF-Drossel 42 angeschlossen sein. An der HF-Drossel 42 kann ein Gleichstromeingang 43 angeschlossen sein. Die PIN-Diode kann demnach parallel zum Antennenanschluss 20 angeschlossen sein. die Baugruppe umfassend den Gleichstromeingang 43, den Gleichstromausgang 41, insbesondere die HF-Drossel 40 und/oder 42 und insbesondere die PIN-Diode 38 kann als Verstimmungsschalter 39 dienen.

Es ist ersichtlich, dass in Figur 20 analog zur Figur 3 eine zweite Induktivität vorhanden ist. Dies ist jedoch nicht notwendig. Ebenso ist in Figur 20 analog zur Figur 2 die Kapazität 11 als variable Kapazität 12 ausgestaltet. Dies ist ebenfalls nicht notwendig. Ebenso ist in Figur 20 analog zur Figur 3 eine zweite Kapazität 14 vorhanden. Dies ist ebenfalls nicht notwendig.

In Figur 20 ist keine Kapazitätsdiode 13 gemäß Figur 4 vorhanden. Dies ist jedoch möglich. Außerdem sind in Figur 20 keine Baueinheit 19 und keine Zusatzinduktivitäten 17, 18 gemäß Figur 5 bzw. 6 vorhanden. Dies ist jedoch möglich. Auch sind in Figur 20 keine PIN-Dioden 23 gemäß Figur 7 vorhanden. Diese können jedoch vorgesehen werden. Zusammenfassend ist zu sagen, dass die oben beschriebenen Merkmale aus Figur 20 einzeln oder in Kombination beliebig mit den Merkmalen jeder der Figuren 1 bis 7 kombiniert werden können.

Figur 21 zeigt eine weitere erfindungsgemäße Antenne 1. Der Speisungsabschnitt 3 dieser Antenne 1 entspricht dem Speisungsabschnitt aus Figur 20. Die oben in Bezug zu Figur 20 genannten Modifikationen sind hier ebenso möglich. Der Empfangsabschnitt 2 ist dagegen anders geformt, nämlich als Schleife, die einen Innenraum umgibt. Der Speisungsabschnitt 3 ist an einem Ende der Schleife angeschlossen. Der Empfangsabschnitt 2 ist länger als der Empfangsabschnitt 2 in Figur 20, sodass der Empfangsabschnitt in Figur 21 eine höhere Induktivität aufweist. Deshalb kann die zweite Induktivität 16 im Falle von Figur 21 kleiner sein als die zweite Induktivität 16 von Figur 20 oder es kann auf eine zweite Induktivität 16 verzichtet werden.

Jeder der in den Figuren 11 bis 19 dargestellten Empfangsabschnitte 2 jeder Antenne 1 kann mit dem Speisungsabschnitt 3 gemäß Figur 20 oder 21 kombiniert werden. Die Länge eines jeden Bereichs des Empfangsabschnitts 2 und/oder das Vorhandensein oder Nichtvorhandensein von Biegungen oder Winkeln zwischen Bereichen des Empfangsabschnitts 2 kann grundsätzlich je nach Bedarf angepasst werden.

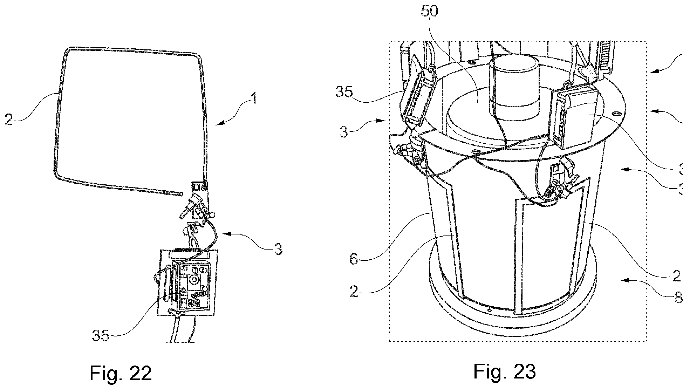

Figur 22 zeigt eine Zeichnung einer erfindungsgemäßen Antenne 1 mit Empfangsabschnitt 2 und Speisungsabschnitt 3. Der Platzbedarf des Speisungsabschnittes ist gering. Der Empfangsabschnitt 2 ist als dünner Kupferleiter ausgestaltet. Der Speisungsabschnitt 3 umfasst einen Vorverstärker.

Figur 23 zeigt eine Antennenanordnung 10 mit vier Antennen 1, die insbesondere gemäß Figur 22 ausgestaltet sind und/oder gleichartig sind. Von Figur 22 abweichend können die Antennen 1 optional mittig gespeist sein und/oder die Empfangsabschnitte können aus einem insbesondere dünnen Profil oder Band aus Kupfer oder Aluminium bestehen. Einige der vier Antennen 1 sind verdeckt. Die Antennen 1 sind in gleichmäßigen Abständen an einem insbesondere kreiszylindrischen Hohlkörper 6 angeordnet, haben also einen Versatz von jeweils 90° um die Mittellängsachse des Hohlkörpers 6. Die Vorverstärker 35 und/oder die Speisungsabschnitte 3 sind beispielsweise im Speisungsteil 9 und/oder außerhalb des Empfangsteils 8 angeordnet. Im Hohlkörper 6 befindet sich ein Phantom 50 für Testmessungen.7

Figur 24 zeigt eine ähnliche Darstellung wie Figur 10, nämlich eine Anwendung einer erfindungsgemäßen Antenne 1. Um Dopplungen zu vermeiden, wird lediglich auf die Unterschiede eingegangen und ansonsten auf die obige Beschreibung der Figur 10 verwiesen. Abweichend von der Darstellung in Figur 10 ist hier die Sendeantenne 60 separat dargestellt, nämlich beispielhaft als J-Pol-Antenne. Die Sendeantenne 60 umfasst beispielhaft einen Speisungsabschnitt 3 und einen Sendeabschnitt 4. Mehrere erfindungsgemäße Antennen 1, insbesondere eine Antennenanordnung, ist sehr nah am nah am Zielobjekt, hier am Gehirn 55 des Patienten 25 platziert. Bevorzugt sind die Antennen 1 der Antennenanordnung in einer gemeinsamen Positionierungseinheit in Bezug zueinander sowie zu dem zu untersuchenden Körperteil angeordnet. Die Positionierungseinheit kann in Form eines Textils, hier z. B. einer Mütze, zum Anziehen an oder Überstülpen über das zu untersuchende Körperteil ausgestaltet sein. Die dichte Platzierung der Antennen 1 sowie die nahe Platzierung am Körper ist durch die erfindungsgemäße Ausgestaltung als reine Empfangsantenne möglich und führt wie beschrieben zu einer verbesserten Bildgebung.

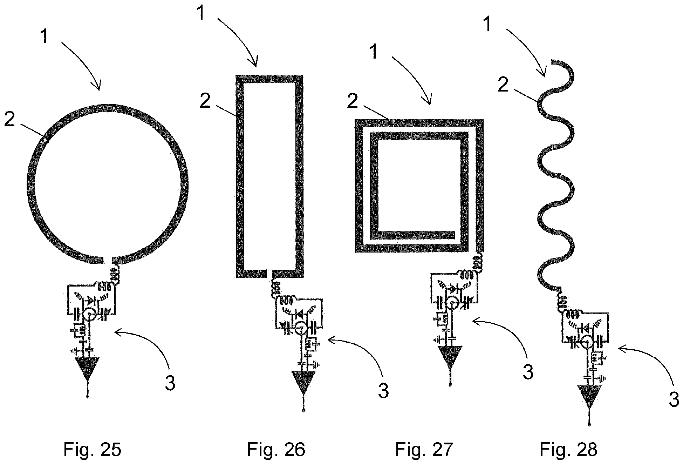

Figuren 25 bis 28 zeigen beispielhaft unterschiedliche Ausgestaltungen erfindungsgemäßer Antennen 1. Die Speisungsabschnitte 3 entsprechen beispielhaft dem in Figur 20 gezeigten Speisungsabschnitt, können jedoch wie beschrieben modifiziert werden. Die Empfangsabschnitte 2 unterscheiden sich hinsichtlich Größe und Form, ähnlich wie bereits in den Figuren 11 bis 17 dargestellt. Beliebige Kombinationen sind möglich. Es zeigt sich, dass die erfindungsgemäße Antenne durch ihre anpassbare Länge und Form besonders flexibel ist.

**Bezugszeichenliste**

| | |
|---|---|
| Antenne | 1 |
| Empfangsabschnitt | 2 |
| Speisungsabschnitt | 3 |
| Sendeabschnitt | 4 |
| Paar | 5 |
| Hohlkörper | 6 |
| Kreiszylindrische Grundform | 7 |
| Empfangsteil | 8 |
| Speisungsteil | 9 |
| Antennenanordnung | 10 |
| Kapazität | 11 |
| Variable Kapazität | 12 |
| Kapazitätsdiode | 13 |
| Zweite Kapazität | 14 |
| Induktivität | 15 |
| Zweite Induktivität | 16 |
| Zusatzinduktivität | 17, 18 |
| Baueinheit | 19 |
| Antennenanschluss | 20 |
| PIN-Diode | 21, 22, 23 |
| Patient | 25 |
| Abzweig | 26 |
| Erster Anschluss | 27 |
| Zweiter Anschluss | 28 |
| PET-System | 30 |
| Körperantenne | 31 |
| Ausgleichsspule | 32 |
| Magnete | 33 |
| Vorverstärker | 35 |
| Anschluss | 36 |
| Kabelfalle | 37 |
| PIN-Diode | 38 |
| Verstimmungsschalter | 39 |
| HF-Drossel | 40 |
| Gleichstromausgang | 41 |
| HF-Drossel | 42 |
| Gleichstromeingang | 43 |
| Induktivität | 45 |
| Kapazität | 46 |
| Phantom | 50 |
| Gehirn | 55 |
| Sendeantenne | 60 |
| Eingangsreflexionsfaktor in dB | S11 [dB] |
| Wellenlänge in MHz | λ [MHz] |
| Sichtfeld | PET FOV |
| Erster Kanal | C1 |
| Zweiter Kanal | C2 |
| Dritter Kanal | C3 |
| Vierter Kanal | C4 |
| Baugruppe | B |
| Weitere Baugruppe | Bx |

## Patentansprüche

1. Antenne (1) für ein bildgebendes Verfahren, nämlich reine Empfangsantenne, wobei die Antenne (1) einen Empfangsabschnitt (2) und einen Speisungsabschnitt (3) aufweist, **dadurch gekennzeichnet, dass** der Speisungsabschnitt (3) eine Kapazität (11) und eine Induktivität (15) umfasst.

2. Antenne (1) nach dem vorhergehenden Anspruch, **dadurch gekennzeichnet, dass** die Antenne (1) ferner einen Vorverstärker (35) aufweist.

3. Antenne (1) nach einem der vorhergehenden Ansprüche, **dadurch gekennzeichnet, dass** die Antenne (1) ferner einen Verstimmungsschalter (39) aufweist, wobei der Verstimmungsschalter insbesondere eine PIN-Diode (38) umfasst.

4. Antenne (1) nach einem der vorhergehenden Ansprüche, **dadurch gekennzeichnet, dass** die Kapazität (11) eine variable Kapazität (12) ist, insbesondere ein variabler Kondensator, und/oder dass die Kapazität (11) als Kapazitätsdiode (20) ausgestaltet ist.

5. Antenne (1) nach einem der vorhergehenden Ansprüche, **dadurch gekennzeichnet, dass** der Speisungsabschnitt (3) eine zweite Kapazität (14) aufweist, um die Antenne (1) anzupassen.

6. Antenne (1) nach einem der vorhergehenden Ansprüche, **dadurch gekennzeichnet, dass** der Speisungsabschnitt (3) eine zweite Induktivität (16) aufweist, um eine Verkürzung des Empfangsabschnitts (2) der Antenne (1) zu ermöglichen.

7. Antenne (1) nach einem der vorhergehenden Ansprüche, **dadurch gekennzeichnet, dass** der Speisungsabschnitt (3) eine oder mehrere selektiv aktivierbare Zusatzinduktivitäten (17, 18) aufweist,
wobei der Speisungsabschnitt (3) insbesondere einen elektrischen Schalter wie z. B. eine PIN-Diode (21, 22) zum Aktivieren einer oder mehrerer Zusatzinduktivitäten (17, 18) aufweist.

8. Antenne (1) nach einem der vorhergehenden Ansprüche, **dadurch gekennzeichnet, dass** der Speisungsabschnitt (3) eine PIN-Diode (23) zum Ein- und Ausschalten der Antenne (1) aufweist.

9. Antenne (1) nach einem der vorhergehenden Ansprüche, **dadurch gekennzeichnet, dass** die Antenne (1) eine Antenne (1) für Magnetresonanztomographie (MRT), Ultrahochfeld-MRT, Magnetresonanzspektroskopie (MRS), Positronen-Emissions-Tomographie-MRT (PET-MRT) und/oder ein Magnetresonanz-basiertes Hybridverfahren ist.

10. Antenne (1) nach einem der vorhergehenden Ansprüche, **dadurch gekennzeichnet, dass** der Empfangsabschnitt (2) der Antenne (1) aus einem im Wesentlichen PET- und/oder SPECT-transparenten Material, beispielsweise Kupfer oder Aluminium, hergestellt ist.

11. Antennenanordnung (10) für ein bildgebendes Verfahren, umfassend mindestens eine oder mindestens zwei Antennen (1) gemäß einem der vorhergehenden Ansprüche.

12. Antennenanordnung (10) nach dem vorhergehenden Anspruch, **dadurch gekennzeichnet, dass** mindestens zwei Antennen (2) der Antennenanordnung (10) unterschiedlich lange Empfangsabschnitte (2) aufweisen.

13. Antennenanordnung (10) nach einem der zwei vorhergehenden Ansprüche, **dadurch gekennzeichnet, dass** die Antennenanordnung (10) einen Empfangsteil (8) aufweist, wobei die Empfangsabschnitte (2) der Antennen (1) im Empfangsteil (8) angeordnet sind, und/oder dass die Antennenanordnung (10) einen insbesondere dem Empfangsteil (8) benachbarten Speisungsteil (9) aufweist, wobei die Speisungsabschnitte (3) der Antennen (1) im Speisungsteil (9) angeordnet sind.

14. Verfahren zum Betreiben einer Antenne (1) nach einem Ansprüche 3 bis 10, bei dem mittels des Verstimmungsschalters (39), insbesondere der PIN-Diode (38), eine Verstimmung der Antenne geschaltet wird.

15. Tomographiesystem, insbesondere für Magnetresonanztomographie (MRT) oder simultane Positronen-Emissions-Tomographie-MRT (PET-MRT), umfassend eine Antenne (1) gemäß einem der Ansprüche 1 bis 10 oder eine Antennenanordnung (10) gemäß einem der Ansprüche 11 bis 13, wobei Antennen des Tomographiesystems insbesondere so angeordnet sind, dass sich die Speisungsabschnitte (3) außerhalb eines Messbereichs des Tomographiesystems befinden.
